Europäisches Patentamt

European Patent Office

Office européen des brevets

(11) Veröffentlichungsnummer: **0 180 936**

A2

(12) # EUROPÄISCHE PATENTANMELDUNG

(21) Anmeldenummer: 85113955.0

(22) Anmeldetag: 02.11.85

(51) Int. Cl.⁴: **H 01 L 39/24**
H 01 L 39/12, C 23 C 16/30

(30) Priorität: 07.11.84 DE 3440590

(43) Veröffentlichungstag der Anmeldung:
14.05.86 Patentblatt 86/20

(84) Benannte Vertragsstaaten:
CH DE FR GB IT LI NL

(71) Anmelder: BROWN, BOVERI & CIE Aktiengesellschaft
Kallstadter Strasse 1
D-6800 Mannheim 31(DE)

(72) Erfinder: Dustmann, Cord-Henrich, Dr. Dipl.-Phys.
Diemstrasse 10
D-6940 Weinheim(DE)

(72) Erfinder: Schmaderer, Franz, Dipl.-Ing.
Türmergasse 13
D-6900 Heidelberg(DE)

(72) Erfinder: Wahl, Georg, Dr. Dipl.-Phys.
Franz-Liszt-Strasse 8
D-6904 Eppelheim(DE)

(74) Vertreter: Kempe, Wolfgang, Dr. et al,
c/o Brown, Boveri & Cie AG Postfach 351
D-6800 Mannheim 1(DE)

(54) **Verfahren zur Herstellung von supraleitenden Faserbündeln.**

(57) Verfahren zur Herstellung von supraleitenden Faserbündeln.

Zur Verbesserung der Supraleitungseigenschaften (Stromtragfähigkeit und kritische Magnetfeldstärke) von Nioboxycarbontrid der allgemeinen Formel $NbC_xN_yO_z$, das auf Trägerfasern mit Hilfe der chemischen Abscheidung aus der Gasphase durch Reaktion von Niobchlorid, Kohlenstoff- und Stickstoffverbindungen abgeschieden wird, wird vorgeschlagen, dem CVD-Reaktionsgas ein sauerstoffhaltiges Gas unter kontrollierten Bedingungen zuzugeben. Als sauerstoffhaltiges Gas kommt insbesondere Wasserdampf $(H_2O)$ in Frage, der mit einem Stoffmengengehalt zwischen 0,15% und 8% dem Reaktionsgas zugegeben wird. Diese Zugabe führt zu einer Verkleinerung der supraleitenden Kristalle. Ferner kann dem CVD-Reaktionsgas eine siliziumhaltige, borhaltige, aluminiumhaltige und/oder andere metallische Verbindung zur Bildung von Niobsilizid, Niobborid, Niobaluminid oder anderer intermetallischer Verbindungen beigemischt werden.

Fig.1

B B C  AKTIENGESELCHAFT
Brown, Boveri & Cie
Baden/Schweiz                    5. Nov. 1984
Mp.Nr. 658/84                    ZPT/P2-La/Fo

Verfahren zur Herstellung von supraleitenden Faserbündeln

Die Erfindung betrifft ein Verfahren zur Herstellung von supraleitenden Faserbündeln, bei dem in einem CVD-Reaktor Nioboxycarbonitrid der allgemeinen Formel $NbC_xN_yO_z$ (x,y,z größer/gleich null und x+y+z kleiner/gleich 1) mit Hilfe der chemischen Abscheidung aus der Gasphase durch Reaktion von Niobchlorid, Kohlenstoff- und Stickstoffverbindungen auf der Trägerfaser abgeschieden wird.

Bei der Weiterentwicklung der Energietechnik im Hinblick auf die Kernfusion und auf supraleitende Generatoren, der Verkehrstechnik (z.B. Magnetschwebebahn), der Umwelttechnik (z.B. Kohlenentschwefelung) und der Hochenergiephysik werden Starkfeldmagnete benötigt, die nur auf Supraleiterbasis hergestellt werden können.

Ein neues aussichtsreiches Supraleitungsmaterial ist $NbC_xN_yO_z$ (x,y,z größer/gleich null und x+y+z kleiner/gleich 1), welches auf Trägerfasern eines Faserbündels (bestehend aus beispielsweise einigen Tausend Fasern mit einem Durchmesser von ca. 5 bis 7 µm) aufgebracht als Faserleiter angewandt werden kann. Nioboxycarbonitrid sowie insbesondere Niobcarbonitrid, bei dem z gleich null ist, zeichnet sich durch hohe kritische Temperaturen, hohe kritische Magnetfelder und hohe kritische Stromdichten aus. Als Trägerfasermaterial kann jeder geeignete Werkstoff verwandt werden (z.B. C, SiC, B, Stahl), der die erforderliche mechanische Festigkeit aufweist. Er dient als zugfeste Matrix und als Substrat für ein chemisches Gasphasenabscheideverfahren (CVD = chemical vapor deposition), bei dem das Niob durch Reaktion von $NbCl_5$ mit $H_2$ in Gegenwart von kohlenstoff- und stickstoffhaltigen Gasen als dünner Film abgeschieden wird. Der CVD-Prozeß wird dabei entweder einstufig (gleichzeitige Nb-Abscheidung und Carbonitrierung) oder zweistufig (Nb-Abscheidung und Carbonitrierung zeitlich aufeinander folgend) durchgeführt.

Verschiedene Verfahren zur Abscheidung von Niobcarbonitrid oder Nioboxycarbonitrid sind durch die DE-AS 28 56 885 und die DE-OS 32 28 729 bekanntgeworden. Während das in der DE-AS 28 56 885 beschriebene Verfahren prinzipiell noch zu grobkörnige supraleitende Schichten liefert, um bestmögliche Supraleitereigenschaften zu erreichen, kann die erforderliche Feinkörnigkeit der supraleitenden Kristalle durch Verfahren gemäß der DE-OS 32 28 729 erreicht werden. Die mittlere Korngröße der B1-Struktur Nioboxycarbonitride ist zwischen 3 und 50 nm einstellbar. Es hat sich jedoch herausgestellt, daß durch die Herstellung von supraleitenden Schichten anhand des Verfahrens nach der DE-OS 32 28 729 die erforderlichen und theroretisch möglichen Supraleitungseigenschaften (hinsichtlich Stromtragfähigkeit und kritischem Magnetfeld) noch nicht erreichbar sind.

Die Erfindung hat sich daher die Aufgabe gestellt, ein Verfahren zur Herstellung von supraleitenden Faserbün deln der eingangs genannten Art anzugeben, durch das die Supraleitereigenschaften von Nioboxycarbonitrid, insbesondere von Niobcarbonitrid, verbessert werden können, d.h. durch das die kritische Stromdichte $J_C$ und die kritische Magnetfeldstärke $H_{C2}$ gegenüber den bei Anwendung der bekannten Verfahren erreichbaren Werten wesentlich angehoben werden können. Insbesondere soll eine genügende Feinkörnigkeit der supraleitenden Schicht erreichbar sein.

Die Aufgabe wird erfindungsgemäß dadurch gelöst, daß zusätzlich zu den genannten Reaktionsgasen in den CVD-Reaktor wenigstens ein sauerstoffhaltiges Gas kontrolliert eingeleitet wird.

Gemäß den bekannten Verfahren (DE-AS 28 56 885 und DE-OS 32 28 729) wird die CVD-Beschichtungsanlage bei Atmosphärendruck bzw. bei reduziertem Druck betrieben, wobei sich ein nicht kontrollierter Sauerstoffverunreinigungsgrad, z.B. durch Lecks in der Anlage oder durch verunreinigtes Fasermaterial oder verunreinigte Reaktionsgase, einstellt. Untersuchungen ergaben, daß der Sauerstoffanteil in der supraleitenden Schicht an der Schwelle des Meßbaren oder darunterlag. Eine Beeinflußung der Schichtbildung durch Sauerstoff oder sauerstoffhaltige Verbindungen wurde bisher bei mit Nioboxycarbonitrid beschichtetem Fasermaterial nicht festgestellt.

Durch Anwendung des erfindungsgemäßen Verfahrens wurde eine überraschend starke Abhängigkeit der supraleitenden Eigenschaften von der Konzentration eines dem CVD-Prozeß zugesetzten sauerstoffhaltigen Gases festgestellt. Als sauerstoffhaltiges Gas hat sich Wasserdampf besonders bewährt, dessen Zugabemenge durch einen thermostatisierten Verdampfer mit angeschlossenem Wärmetauscher und Drosselventil genau einstellbar ist.

Es hat sich herausgestellt, daß durch Anwendung des erfindungsgemäßen Verfahrens insbesondere die kritische Stromdichte $J_C$ im Hochfeldbereich (z.B. bei 13 Tesla) um den Faktor von ca. 20 erhöht werden kann. Zusätzlich führt die Zugabe von $H_2O$ zu einer geringeren Magnetfeldabhängigkeit des kritischen Stromes $J_C$, und das kritische Magnetfeld kann dadurch entscheidend erhöht werden ($H_{C2}$ liegt bei etwa 40 bis 50 Tesla).

Die kontinuierliche Zugabe von $H_2O$, während des Niobabscheideprozesses beeinflußt die Keimbildung beim Wachstumsprozeß der supraleitenden Kristalle und führt zur Kornverfeinerung der abgeschiedenen Schicht, was durch Röntgenanalysen nachgewiesen werden konnte. Ein Grund hierfür mag darin zu sehen sein, daß der Sauerstoff des $H_2O$ wahrscheinlich die Oberflächendiffusion auf der Substratoberfläche verringert und zusammen mit einer hohen Übersättigung des Reaktionsgases die Keimbildung erhöht.

Die entscheidende Verbesserung der supraleitenden Eigenschaften ist bei einem $H_2O$-Stoffmengengehalt zwischen 0,15 % und 8 % des Reaktionsgasgemisches feststellbar. Als besonders günstiger Bereich ist ein $H_2O$-Stoffmengengehalt zwischen 1,2 % und 2,5 % anzusehen. Die besten Ergebnisse wurden bisher bei einem $H_2O$-Stoffmengengehalt um 1,7 % erzielt.

Bei Anwendung eines 2-stufigen CVD-Verfahrens ist es vorteilhaft, den Wasserdampf nicht nur im Bereich der Niobabscheidung zuzugeben, sondern auch im Bereich der zweiten Stufe, in der die Carbonitrierung erfolgt. Die zusätzliche $H_2O$-Zugabe (vorzugsweise die gleiche Menge wie in Stufe 1) in Stufe 2 verhindert die teilweise oder ganze Wegreduzierung des Sauerstoffes aus der NbCN-Schicht durch die Kohlenstoff- und Stickstoffverbindungen (z.B. Methan bzw. Ammoniak).

Mp.Nr. 658/84                    5              0180936

Eine weitere besonders vorteilhafte Weiterbildung des erfindungsgemäßen Verfahrens ist darin zu sehen, daß dem CVD-Reaktionsgas eine siliziumhaltige, borhaltige, aluminiumhaltige und/oder eine andere metallische Verbindung in gasförmigem Aggregatzustand zur Bildung von Niobsilizid, Niobborit, Niobaluminid oder anderer intermetallischer Verbindungen beigemischt wird.

Durch diese Beimischung werden sogenannte Pinningzentren gebildet, durch die die kritische Magnetfeldstärke $H_{C2}$ erhöht wird, während sich die Magnetfeldabhängigkeit des kritischen Stromes $J_C$ verringert. Pinningzentren sind Inhomogenitäten im supraleitenden Werkstoff in der Größenordnung der Koherenzlänge von etwa 5 nm, die sich in den elektrischen Eigenschaften wesentlich vom supraleitenden Werkstoff unterscheiden. Bei der deutlichen Erhöhung der kritischen Magnetfeldstärke $H_{C2}$ kann eine geringe Abnahme der Stromtragfähigkeit (bei steigendem Beimischungsanteil) in Kauf genommen werden.

Als Beimischungen sind beispielsweise Siliziumhalogenide wie Siliziumchlorid ($SiCl_4$) geeignet, die während der CVD-Abscheidung in Niobsilizid ($Nb_5Si_3$) übergehen, welches im supraleitenden Werkstoff als Pinningkörner oder Pinninggrenzschichten ausscheidet.

Als Beimischungen kommen ferner Borhalogenide wie Borchlorid ($BCl_3$) in Frage, die in Niobborid ($NbB_2$) übergehen.

Ferner können dem CVD-Reaktionsgas auch gasförmige Metallhalogenide, z.B. Aluminiumchlorid ($AlCl_3$) zugeführt werden, durch die intermetallische Verbindungen, wie Niobaluminid ($Nb_3Al$), als Pinningzentren gebildet werden.

Statt der genannten Halogenide können auch Alkyle (z.B.

Metallalkyle wie Triisobutylaluminium) oder Acetylacetonate des Silizium, Bor, Aluminium oder anderer Metalle als Beimischungen dienen.

Der Anteil der Beimischungen am CVD-Reaktionsgas liegt in vorteilhafter Weise zwischen 0,2 % und 1 % Stoffmengengehalt. Ein günstiger Bereich des Stoffmengengehaltes der Beimischungen liegt zwischen 0,45 % und 0,65 %. Für die Beimischung von Siliziumchlorid ($SiCl_4$) kann ein Stoffmengengehalt, der bei 0,55 % liegt, als besonders günstig angesehen werden.

Es ist vorteilhaft, die gasförmigen Beimischungen durch Zugabe von Wasserstoffgas ($H_2$) und/oder Stickstoffgas ($N_2$), welche als Trägergas dienen, in den CVD-Reaktor einzuspülen.

Weitere vorteilhafte Weiterbildungen und Ausgestaltungen der Erfindung sowie weitere Vorteile werden anhand eines Ausführungsbeispieles der Erfindung näher erläutert und beschrieben.

Es zeigt:

Fig. 1      Die schematische Darstellung einer CVD-Apparatur zur NbCN-Beschichtung von C-Fasern,

Fig. 2      die schematische Darstellung einer $H_2O$-Verdampfungseinrichtung,

Fig. 3      ein Diagramm, das die Halbwertsbreite der (200)-Röntgenlinie von $NbC_xN_y$ in Abhängigkeit von der $H_2O$-Verdampfungstemperatur darstellt,

Fig. 4      ein Diagramm, das die kritische Stromdichte $J_C$ in Abhängigkeit von der $H_2O$-Verdampfungstemperatur darstellt und

Fig. 5      ein Diagramm, das die kritische Stromdichte $J_C$ in Abhängigkeit von der äußeren Magnetfeldstärke $H_A$ darstellt.

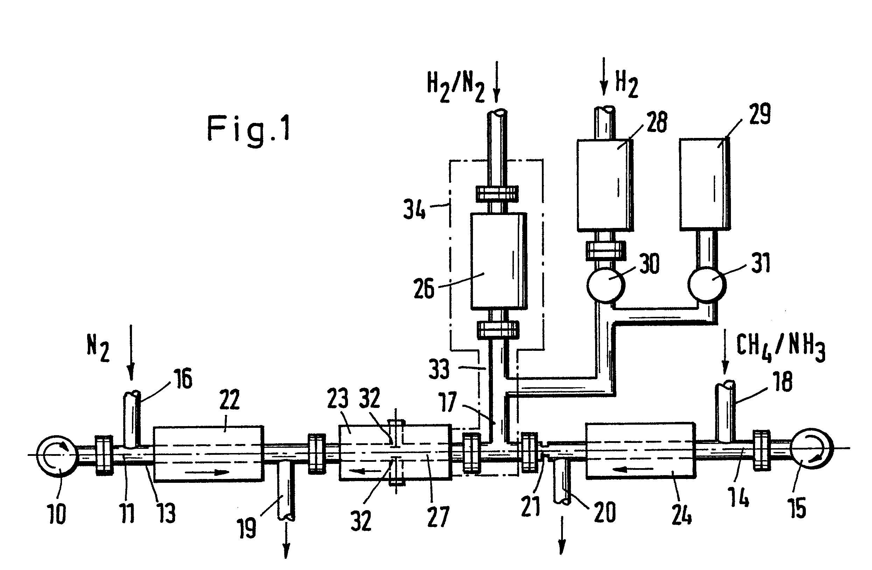

Die Fig. 1 zeigt eine CVD-Abscheideapparatur, mittels der in einem zweistufigen Verfahren Nioboxycarbonitrid auf Kohlenstoffasern abgeschieden wird.

In einer Abspulkammer 10 befindet sich eine Rohmaterialspule, die die unbeschichteten Trägerfasern 11 (Kohlenstoffasern) trägt. Die Trägerfasern 11 werden durch eine Fasertransporteinrichtung, die nicht dargestellt wurde, durch ein Quarzrohr 13, in dem die Beschichtung der Trägerfasern 11 erfolgt, gezogen. Die beschichteten Fasern 14 werden auf eine in einer Aufspulkammer 15 befindlichen Aufnahmespule aufgehaspelt. In dem Quarzrohr 13 befinden sich drei Gaseinlaßstutzen 16,17,18, durch die Stickstoff $N_2$, gasförmiges Niobchlorid $NbCl_5$ mit einem Gemisch aus Wasserstoff und Stickstoff $H_2/N_2$ als Trägergas, Wasserdampf $H_2O$ mit dem Trägergas Wasserstoff $H_2$, gasförmiges Siliziumchlorid $SiCl_4$ und ein Gemisch aus Methan und Ammoniak $CH_4/NH_3$ in das Quarzrohr 13 eingelassen werden können. Über zwei Pumpstutzen 19,20 läßt sich das innerhalb des Quarzrohres 13 befindliche Gas abpumpen und ein Unterdruck im Quarzrohr 13 herstellen. Durch eine Drosselstelle 21, durch die sich das Faserbündel ziehen läßt, wird ein Druckausgleich im Quarzrohr 13 verhindert, so daß sich innerhalb des Quarzrohres 13 unterschiedliche Drücke vor und hinter der Drosselstelle 21 einstellen können.

Während ihres Transportes von der Abspulkammer 10 zur Aufspulkammer 15 tritt das Faserbündel durch drei Öfen 22, 23,24 (ein möglicher vierter Ofen, in dem die beschichteten Fasern mit einer hochleitfähigen Kupferschicht überzogen werden können, siehe DE-OS 32 28 729,

Mp.Nr. 658/84                    8          0180936

wurde hier nicht dargestellt).

Im ersten Ofen 22 werden die Kohlenstoffasern 11, falls
notwendig, gereinigt, in dem sie in einer Stickstoff-
oder Wasserstoffatmosphäre aufgeheizt werden. Die Gaszufuhrmenge in den Gaseinlaßstutzen 16 liegt beispielsweise zwischen 1 und 20 1 pro Stunde. Die Ofentemperatur
wird auf 600 bis 1000°C eingestellt.

Im zweiten Ofen 23 (CVD-Reaktor) werden die Fasern 11 in
einem $NbCl_5$-$H_2$-$N_2$-Gasgemisch mit einer Nb-haltigen Verbindung beschichtet. Das erforderliche $NbCl_5$-Gas wird
aus einem Feststoffverdampfer 26, der jedoch auch durch
einen Verdampfer aus der flüssigen Phase ersetzt werden
kann, in die Gasphase überführt und mit einem Wasserstoff-Stickstoff-Gemisch, das als Trägergas dient, über
den Gaseinlaßstutzen 17 in den CVD-Reaktor 27 geleitet.
Die Temperatur des Feststoffverdampfers 26 wird hierbei
auf einen Wert zwischen 80 und 200 °C eingestellt. Die
Zuflußmenge des $NbCl_5$-$H_2$-$N_2$-Gasgemisches liegt zwischen
2 und 20 1 pro Stunde. Die Temperatur des Ofens 23 wird
zwischen 600 und 1000 °C eingestellt. Das Restgas wird
über den Pumpstutzen 19 abgepumpt.

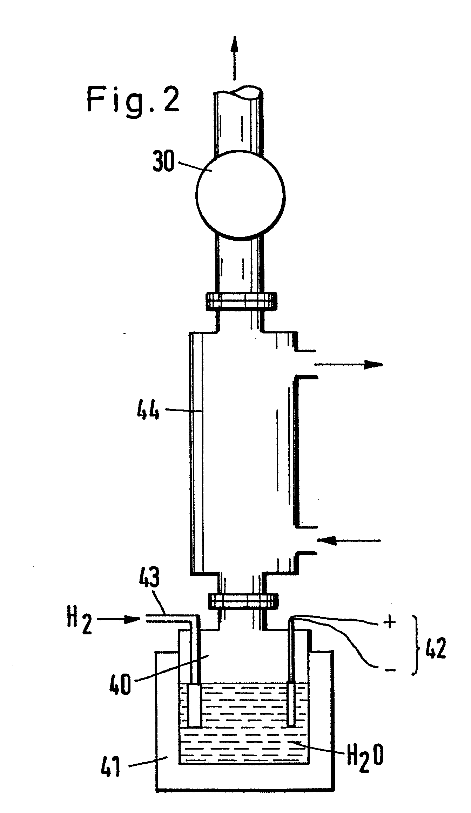

Dem gasförmigen Niobchlorid werden Wasserdampf und gasförmiges Siliziumchlorid beigemischt, die ebenfalls über
den Gaseinlaßstutzen 17 in den CVD-Reaktor 27 gelangen.
Der Wasserdampf wird in einer Verdampfungseinrichtung 28
erzeugt, die später anhand Fig. 2 näher erläutert wird.
Zur Verdampfung des Siliziumchlorids wird ebenfalls eine
Verdampfungseinrichtung 29 verwendet. Diese besteht aus
einem Glasbehälter, in dem das Siliziumchlorid auf ca.
30°C erwärmt und konstant gehalten wird. Bei dieser Temperatur bildet sich ein ausreichender Siliziumchlorid-
Dampfdruck aus. Zur Einstellung der erforderlichen Wasserdampf- und Siliziumchlorid-Mengen dienen thermische
Massendurchflußmesser 30,31, die zwischen der jeweiligen

Mp.Nr. 658/84 9 0180936

Verdampfungseinrichtung 28, 29 und dem Gaseinlaßstutzen 17 angeordnet sind. Anhand der thermischen Massendurchflußmesser 30,31 läßt sich die Durchflußmenge sowohl einstellen als auch ablesen.

Im dritten Ofen 24 erfolgt die zweite Stufe des CVD-Verfahrens zur Herstellung der supraleitenden Schicht. Durch den Gaseinlaßstutzen 18 wird ein kohlenstoff- und stickstoffhaltiges Gasgemisch (z.B. 0 bis 50 Vol.- % Methan, 0 bis 50 Vol.-% Ammoniak und der Rest Stickstoff) in das Quarzrohr 13 eingelassen. Die Zuflußmenge von Methan und Ammoniak liegt jeweils zwischen 2 und 15 l pro Stunde. Der dritte Ofen 24 wird auf eine Temperatur zwischen 700 und 1100°C temperiert. Dabei dissoziieren die Gase Methan und Ammoniak und es dringen Kohlenstoff und Stickstoff in die Niobschicht ein. Das Restgas wird über den Pumpstutzen 20 abgesaugt.

Um zu vermeiden, daß in der zweiten Stufe des CVD-Verfahrens durch die Kohlenstoff- und Stickstoffverbindungen der in der ersten Stufe in die NbCN-Schicht eingelagerte Sauerstoff reduziert und damit wieder aus der supraleitenden Schicht entfernt wird, kann es vorteilhaft sein, am Gaseinlaßstutzen 18 auch eine $H_2O$-Verdampfungseinrichtung anzuschließen, die mit der bereits erwähnten Verdampfungseinrichtung 21 identisch sein kann.

Im Prinzip kann in der Abscheideapparatur auch einstufig gearbeitet werden, d.h. im Ofen 23 wird gleichzeitig Niob abgeschieden und in einer kohlenstoff- und stickstoffhaltigen Atmosphäre carbonitriert.

Das Quarzrohr 13 (Reaktor) und die Gasversorgung ist durch geeignet angebrachte Strömungswiderstände (Drosselstellen 21) und geeignete Auslegung der Pumpen, die an die Pumpstutzen 19,20 angeschlossen sind, so konstruiert, daß die Gase in den Öfen 22,23,24 jeweils in Pfeilrichtung strömen.

Die Niobabscheidung in dem Ofen 23 kann auch unter Plasmaaktivierung erfolgen. Die Plasmaaktivierung kann durch eine Gasentladung zwischen zwei sich gegenüberliegenden Elektroden-Platten 32 angeregt werden.

Das Quarzrohr 33 zwischen Feststoffverdampfer 26 und Ofen 23 wird zweckmäßigerweise zur Aufrechterhaltung der Gastemperatur thermostabilisiert. Diese Maßnahme ist durch eine strichpunktierte Linie 34 in Figur 1 angedeutet.

Im folgenden werden einige für die dargestellte Abscheideapparatur vorteilhafte Verfahrensparameter angegeben:

Temperaturen:

| | | |
|---|---|---|
| $T_{Ofen 22}$ | = | 1000°C |
| $T_{Ofen 23}$ | = | 960°C |
| $T_{Ofen 24}$ | = | 1100°C |
| $T_{NbCl5(Kolonne)}$ | = | 113°C |
| $T_{H2O}$ | = | 15°C |
| $T_{SiCl4}$ | = | 30°C |

Gesamtdruck im CVD-Raktor 27:

$$p \quad = \quad 0,6 kPa$$

Gaszuflußmengen:

| | | |
|---|---|---|
| $i_{16(N2)}$ | = | $10\ lh^{-1}$ |
| $i_{17(N2)}$ | = | $10\ lh^{-1}$ |
| $i_{17(H2)}$ | = | $10\ lh^{-1}$ |
| $i_{18(NH3)}$ | = | $10\ lh^{-1}$ |
| $i_{18(CH4)}$ | = | $10\ lh^{-1}$ |

Fasergeschwindigkeit:

$$v_{Faser} \quad = \quad 6 \text{ cm min}^{-1}$$

In Figur 2 ist die Verdampfungseinrichtung 28 der Fig. 1 näher dargestellt. In einem Verdampfer 40 befindet sich Wasser $H_2O$. Der Verdampfer 40 ist von einem thermostatisierten Erwärmer 41 umgeben, der eine gleichmäßige Wassertemperatur von 30°C einstellt. Die Wassertemperatur wird durch ein Thermoelement 42 gemessen und überwacht. In das Wasser wird durch eine Zuflußleitung 43 Wasserstoffgas $H_2$ eingeleitet. Oberhalb der Wasseroberfläche herrscht ein Gesamtdruck von 100kPa, der sich aus den Partialdrücken des Wassers und des Wasserstoffs zusammensetzt.

Das Gasgemisch aus Wasser und Wasserstoff tritt aus dem Verdampfer 40 aus und strömt durch einen Wärmetauscher 44, dem sich ein einstellbarer thermischer Massendurchflußmesser 30, der auch in Fig. 1 gezeigt ist, anschießt.

Im Wärmetauscher (Kolonne) 44 erfolgt eine Temperierung des Wasser/Wasserstoff-Gemisches. Hierbei stellt sich ein Wasserpartialdruck ein, der der Dampfdruckkurve des Wassers folgt. Beispielsweise liegt bei einer Gastemperatur von etwa -16°C der Wasserpartialdruck bei 0,15 kPa, was einem Stoffmengengehalt $x_{H_2O}$ von 0,15 % entspricht. Bei einer Gastemperatur von etwa 40°C liegt der Stoffmengengehalt $x_{H_2O}$ bei 8 % (unter der Voraussetzung, daß der Gesamtdruck 100kPa ist). Anhand der Wärmetauschertemperatur läßt sich somit der Stoffmengengehalt $x_{H_2O}$ einstellen. Ein für den CVD-Prozeß besonders günstiger Temperaturbereich des Gases im Wärmetauscher 44 liegt zwischen 10°C und 21°C, was gemäß der Dampfdruckkurve einem Stoffmengengehalt x zwischen 1,2 % und 2,5 % entspricht. Eine bevorzugte Einstellung liegt bei 15°C, d.h. einem Stoffmengengehalt x von 1,7 %.

Im Massendurchflußmesser 30 wird der Wasser/Wasserstoff-Gesamtdruck von 100kPa auf 0,6kPa, den Gesamtdruck p im CVD-Reaktor, gesenkt. Das Verhältnis zwischen dem Teildruck des Wasserdampfes und dem Gesamtdruck, d.h. der Stoffmengengehalt des Wassers, ändert sich hierbei nicht.

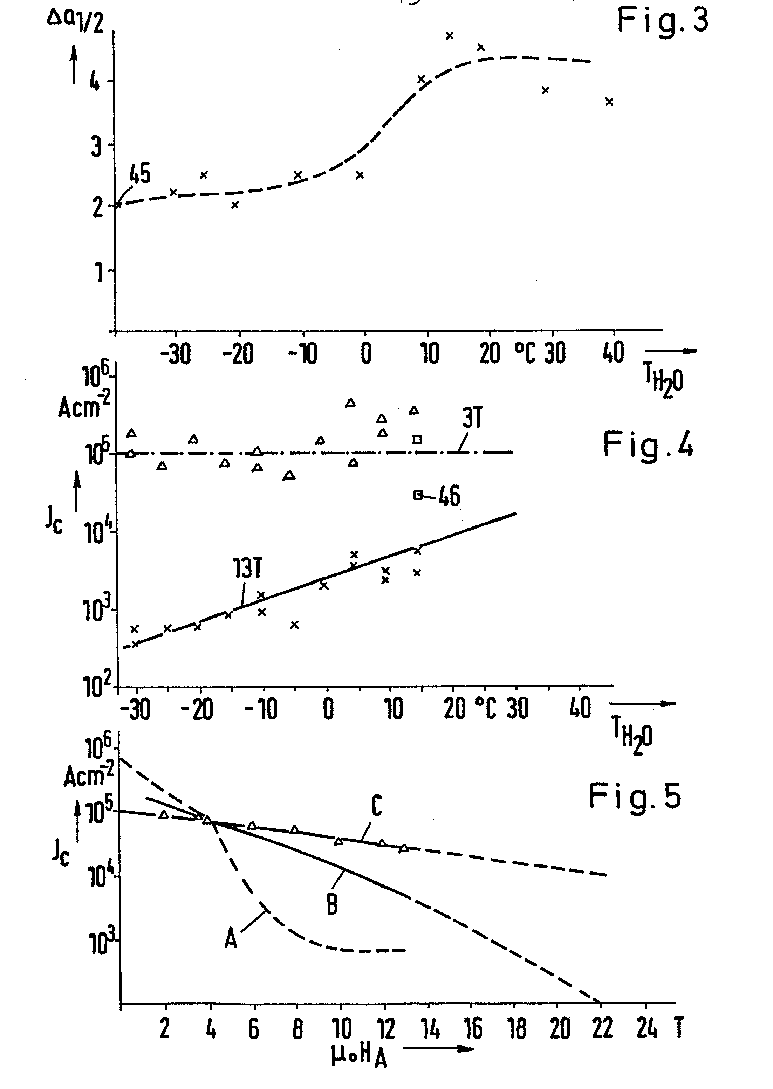

Trotz der $H_2O$-Zugabe zum CVD-Reaktionsgas konnte bisher kein nennenswerter Sauerstoffgehalt in der supraleitenden Schicht festgestellt werden. Es konnte jedoch anhand der Röntgenstrukturanalyse nachgewiesen werden, daß die Anwesenheit von Wasserdampf im Reaktionsgas das Wachstum der Niobcarbonitridkristalle beeinflußt. Es wurde die Halbwertsbreite der (200)-Röntgenlinie in Abhängigkeit von der $H_2O$-Temperatur im Wärmetauscher 44 gemessen. Das Meßergebnis ist in Figur 3 dargestellt. Die Halbwertsbreite (delta alpha $_{1/2}$) der Röntgenlinie ist in der Ordinate in willkürlichen Einheiten dargestellt.

Es zeigt sich, daß bei Gastemperaturen im Wärmetauscher, die zwischen -16°C (das entspricht einem $H_2O$-Stoffmengengehalt von 0,15 %) und +40°C ($H_2O$-Stoffmengengehalt von 8 %) sich die Röntgenlinienhalbwertsbreite in etwa verdoppelt. Da eine zunehmende Röntgenlinienhalbwertsbreite auf eine Kornverkleinerung des Kristallgefüges hinweist, läßt sich durch das Meßergebnis eine Kornverkleinerung in der supraleitenden Schicht nachweisen. Der Meßpunkt 45, der unmittelbar an der Ordinate liegt, wurde an supraleitenden Schichten ermittelt, die ohne Zugabe von Wasser hergestellt wurden. Die Kornverfeinerung wurde ebenfalls durch Transmissions-Elektronenmikroskopie verifiziert.

Die Zugabe von $H_2O$ führt zu einer geringeren Magnetfeldabhängigkeit der kritischen Stromdichte $J_C$, wie aus Figur 4 ableitbar ist. In Figur 4 ist die kritische Stromdichte $J_C$ über der Wärmetauschertemperatur $T_{H2O}$ dargestellt. Es wurde eine Messung bei 3T und eine weitere bei 13T durchgeführt (Temperatur T =4,7K). Im Niederfeldbereich (3T) ist die kritische Stromdichte $J_C$ nahezu unabhängig von der $H_2O$-Zugabe. Im Hochfeldbereich (13T) ist dagegen eine deutliche Abhängigkeit der kritischen Stromdichte $J_C$ von dem Stoffmengengehalt des Wassers im Reaktionsgas (hier ausgedrückt durch die Gastemperatur im Wärmetauscher) nachweisbar. Für Gastemperaturen im Wärmetauscher 44 bei +15°C (das entspricht einem Stoffmengengehalt von etwa 1,7 %) ist der Unterschied der kritischen Stromdichte $J_C$ zwischen Niederfeld- und Hochfeldbereich wesentlich geringer, als für geringere $H_2O$-Konzentrationen.

In die Figur 4 wurde ferner ein Meßpunkt 46 eingetragen, der für eine supraleitende Schicht bei 13 T ermittelt wurde, bei deren Herstellung dem CVD-Reaktionsgas sowohl $H_2O$ (15°C) als auch $SiCl_4$ (0,25 $lh^{-1}$) zugegeben wurden. Der Meßwert macht deutlich, daß die $SiCl_4$-Zugabe zu einer weiteren Verringerung der Magnetfeldabhängigkeit der kritischen Stromdichte $J_C$ führt.

Durch die Wasser- und Siliziumchlorid-Zugabe zum Reaktionsgemisch kann das kritische Magnetfeld entscheidend erhöht werden, wie aus Figur 5 zu entnehmen ist. Dort ist die kritische Stromdichte $J_C$ über der Induktion des äußeren Magnetfeldes $H_A$ dargestellt. Die Kurve A wurde bei Supraleitern, die ohne Zugabe von Wasser und Siliziumchlorid hergestellt wurde, aufgenommen. Die Kurve B entspricht einer Zugabe von Wasser bei $T_{H2O}$ = + 15°C (Stoffmengengehalt von 1,7 %). Die Kurve C wurde an Supraleitern gemessen, die durch ein CVD-Verfahren hergestellt wurden, bei dem dem Reaktionsgemisch sowohl

Wasser ($T_{H2O}$ = 15°C) als auch Siliziumchlorid (0,25,$lh^{-1}$) zugegeben wurde.

Den Kurven aus Fig. 5 ist zu entnehmen, daß oberhalb einer Induktion von etwa 4T die Kurven B und C deutlich oberhalb der Kurve A (ohne Wasser- oder Siliziumchlorid-Zugabe) liegen. Für die Kurve B kann ein kritisches Magnetfeld von ca. 22T und für die Kurve C ein kritisches Magnetfeld von 40 bis 50T extrapoliert werden.

Ansprüche

1. Verfahren zur Herstellung von supraleitenden Faserbündeln, bei dem in einem CVD-Reaktor Nioboxycarbonitrid der allgemeinen Formel $NbC_xN_yO_z$ (x,y,z größer/gleich null und x+y+z kleiner/gleich eins) mit Hilfe der chemischen Abscheidung aus der Gasphase durch Reaktion von Niobchlorid, Kohlenstoff- und Stickstoffverbindungen auf Trägerfasern abgeschieden wird, dadurch gekennzeichnet, daß zusätzlich zu den genannten Reaktionsgasen in den CVD-Reaktor wenigstens ein sauerstoffhaltiges Gas kontrolliert eingeleitet wird.

2. Verfahren nach Anspruch 1, dadurch gekennzeichnet, daß das sauerstoffhaltige Gas Wasserdampf ($H_2O$) ist.

3. Verfahren nach Anspruch 2, dadurch gekennzeichnet, daß die Zusammensetzung der Reaktionsgase so eingestellt wird, daß der $H_2O$-Stoffmengengehalt $x_{H_2O}$ zwischen 0,15 % und 8 %, vorzugsweise zwischen 1,2% und 2,5%, insbesondere bei 1,7% liegt.

4. Verfahren nach einem der Ansprüche 1 bis 3, bei dem der CVD-Prozeß zweistufig durchgeführt wird, wobei in einem ersten Verfahrensschritt das Niob auf die Trägerfasern abgeschieden wird und in einem zweiten Verfahrensschritt kohlenstoff- und stickstoffhaltige Verbindungen zur Carbonitrierung der Nb-Schicht zugegeben werden, dadurch gekennzeichnet, daß die Zugabe der sauerstoffhaltigen Gase bei beiden Verfahrensschritten erfolgt.

5. Verfahren nach Anspruch 4, dadurch gekennzeichnet, daß bei beiden Verfahrensschritten der gleiche Stoffmengengehalt an sauerstoffhaltigen Gasen eingestellt wird.

6. Verfahren nach einem der Ansprüche 1 bis 5, dadurch gekennzeichnet, daß dem Reaktionsgas eine gasförmige, siliziumhaltige Verbindung zur Bildung von Niobsilizid ($Nb_5Si_3$) beigemischt wird.

7. Verfahren nach einem der Ansprüche 1 bis 6, dadurch gekennzeichnet, daß dem Raktionsgas eine gasförmige, borhaltige Verbindung zur Bildung von Niobborid ($NbB_2$) beigemischt wird.

8. Verfahren nach einem der Ansprüche 1 bis 7, dadurch gekennzeichnet, daß dem Reaktionsgas eine metallhaltige Verbindung (z.B. aluminiumhaltige Verbindung) zur Bildung intermetallischer Verbindungen wie Aluminide ($Nb_3Al$) beigemischt wird.

9. Verfahren nach einem der Ansprüche 1 bis 8, dadurch gekennzeichnet, daß die Zusammensetzung des Reaktionsgases so eingestellt wird, daß der Stoffmengengehalt $x_B$ der Beimischungen (silizium-, bor- und/oder metallhaltige Verbindungen) zwischen 0,2 % und 1 %, vorzugsweise zwischen 0,45% und 0,65%, insbesondere bei 0,55% liegt.

10. Verfahren nach einem der Ansprüche der 1 bis 9, dadurch gekennzeichnet, daß die Beimischungen (silizium-, bor- und/oder metallhaltige Verbindungen) durch Wasserstoffgas ($H_2$) und/oder Stickstoffgas ($N_2$) als Trägergas in den CVD-Reaktor eingespült werden.

Fig.1

$H_2/N_2$

$H_2$

$N_2$

$CH_4/NH_3$

# Fig.2

Fig. 3

Fig. 4

Fig. 5